# EUROPEAN PATENT APPLICATION

(11) **EP 4 489 533 A1**
(43) Date of publication of application: **08.01.2025**
(21) Application number: 24164505.0
(22) Date of filing: 19.03.2024
(51) Int. Cl.: H05K 3/40, H05K 1/03, H05K 1/09, H05K 1/11, H05K 3/00, H05K 3/06

(54) **COMPONENT CARRIER AND METHOD OF MANUFACTURING THE COMPONENT CARRIER**

(30) Priority: 07.07.2023 CN 202310829943
(71) Applicant: AT & S Austria Technologie & Systemtechnik Aktiengesellschaft, 8700 Leoben-Hinterberg (AT)
(72) Inventor: LEE, Minwoo, Chongqing, 401120 (CN)
(74) Representative: Dilg, Haeusler, Schindelmann Patentanwaltsgesellschaft mbH

(57) **Abstract**

The present invention provides a component carrier and a method of manufacturing the component carrier. The component carrier (100) comprises a stack having at least one electrically conductive layer structure and at least one electrically insulating layer structure, wherein the stack comprises i) a support layer structure (110) comprising at least one through-hole (115); ii) a metal paste filling material ( 120) in the through-hole (115); and iii) a metal pad (130) provided on and extending from an exterior main surface (111) of the support layer structure (110);wherein the metal paste filing material (120) in the through hole (115) and the metal pad (130) comprise at least partially the same material.

## Description

### Field of the Invention

The invention relates to a component carrier with a stack having a support layer structure, a metal paste filling material, and a metal pad. Further, the invention relates to a method of manufacturing said component carrier.

Accordingly, the invention may relate to the technical field of component carriers, such as printed circuit boards or IC substrates.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, manufacturing reliable (electrical) interconnections (such as vias) in a component carrier may be a challenge. Conventionally, through-holes extending through a dielectric layer are formed by drilling, e.g. mechanical or laser drilling. Afterwards, the through-holes are filled by electrically conductive material, normally copper, using a plating process. While in some applications the whole through-holes is filled, in other applications only sidewalls are covered with electrically conductive material (plated through-holes).

However, the conventional approaches may have some drawbacks. In order to perform the plating process, a seed layer has to be applied normally to the through-hole sidewalls. Thereby, high aspect ratios (long and thin interconnections) may be difficult to produce. In particular, voids/dimples may be produced by the plating process. Plating can require long process times and there may be a risk of over-plating. Additionally, special applications such as glass substrates may be a further challenge, since they may brake during a conventional manufacture process.

### Summary of the Invention

There may be a need to provide a component carrier with reliable electrical interconnections, in particular with a high aspect ratio, in an efficient manner.

A component carrier and a manufacturing method are described.

According to an aspect of the invention, there is described a component carrier, comprising a stack having at least one electrically conductive layer structure and at least one electrically insulating layer structure, wherein the stack comprises:
i) a support layer structure (e.g. a glass support layer structure or glass core) comprising at least one through-hole (e.g. a laser via);
ii) a metal paste filling material (e.g. comprising metal particles and a bonding/paste material) in the through-hole (thereby filling the through-hole, in particular completely filling); and
iii) a metal pad (e.g. a metal paste pad, a plating pad, metal paste, or a plating mixed pad) provided on and extending from an exterior main surface (oriented perpendicular to the stacking direction Z, i.e. along X, Y) of the support layer structure.
Hereby, the metal paste filing material in the through hole and the metal pad comprise at least partially the same material (for example metal particles and/or metal such as copper).

According to a further aspect of the invention, there is described a method of manufacturing a component carrier (e.g. as described above), wherein the method comprises:
i) providing a stack with at least one electrically conductive layer structure, at least one electrically insulating layer structure, and a support layer structure;
ii) forming a through-hole in the support layer structure;
iii) filling the through-hole with a metal paste filling material, in particular comprising metal particles and a bonding material (to be sintered); and iv) forming a metal pad on and extending from an exterior main surface of the support layer structure.
Hereby, the metal paste filing material in the through hole and the metal pad comprise at least partially the same material (for example metal particles and/or copper).

According to a further aspect of the invention, there is described a component carrier (in particular comprising a stack with at least one electrically conductive layer structure, at least one electrically insulating layer structure), which comprises:
i) a support layer structure having a through-hole with slanted sidewalls over its entire extension or straight sidewalls; and
ii) a metal paste filling in the through-hole being in direct physical contact with sidewalls of the support layer structure delimiting the through-hole.

According to a further aspect of the invention, there is described a method of manufacturing a component carrier (in particular comprising a stack with at least one electrically conductive layer structure, at least one electrically insulating layer structure), wherein the method comprises:
i) providing a support layer structure having a through-hole with slanted or straight sidewalls along its entire extension; and
ii) filling the through-hole with a metal paste filling so that the metal paste filling is in direct physical contact with sidewalls of the support layer structure delimiting the through-hole.

In the present context, the term "support layer structure" may in particular refer to a layer structure, configured to be arranged in the layer stack of a component carrier, and which comprises at least one through hole. The through hole may be formed by drilling and preferably extends through the support layer structure, in particular in a thickness direction (Z) perpendicular to the directions (X, Y) of main extension of the support layer structure. In an example, the support layer structure is configured as a core layer structure. In a further example, the support layer structure comprises a fully stable material, i.e. no partially cured resin. In an embodiment, the support layer structure is configured as a glass layer structure, in particular a glass core. In a further example, the support layer structure comprises a non-resin material. The support layer structure may comprise at least one electrically conductive layer and/or at least one electrically insulating layer.

In the present context, the term "metal paste filling material" may in particular refer to a material that comprises a metal paste and is configured to (at least partially, in particular fully) fill a through hole of a support layer structure. When being filled into said through hole, the metal paste filling material may comprise metal particles and a bonding material such as copper nano particles with resin or copper and silver nano particles with resin or copper and silver nano particles with other conductive material like carbon nanotubes. In this state, the metal paste may be at least partially viscous. After being filled into said through-hole, the metal paste filling material may be made subject of a sintering process, thereby stabilizing/fusing the material and removing/decreasing the viscosity. Besides the through-hole, the metal paste filling material may also be arranged on top of the support layer structure, in particular during the manufacture process. Such a metal paste filling material layer may be partially removed, so that metal paste filling material pads remain that are provided on (and directly connected to) the metal paste filling material arranged within the through-hole.

In the present context, the term "metal pad" may in particular refer to a pad-like structure that comprises or consists of metal and is arranged on top of a metal paste filling material, either as a metal paste filling material arranged in a through hole or as a metal paste filling material pad or partially arranged below the layer of metal paste filling material. In an example, the metal pad comprises a metal paste material that is comparable or similar to the metal paste filling material. For example, the metal pad material may comprise metal particles and eventually a bonding material. In this example, a metal paste filling material pad may be seen as a metal pad. In another example, the metal pad comprises (only) metal such as copper. In this example, the metal pad may be formed by a plating process (plating pad).

In the context of the present document, the term "component carrier" may particularly denote any support structure which is capable of accommodating one or more components thereon and/or therein for providing mechanical support and/or electrical connectivity and/or thermal conductivity. In other words, a component carrier may be configured as a mechanical and/or electronic and/or thermal carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products. It comprises at least one electrically conductive structure and at least one electrically insulating structure. It can function as an electrical and/or mechanical and/or thermal platform in an IC package, when the components are mounted on the component carrier or embedded in the component carrier.

According to an exemplary embodiment, the invention may be based on the idea that a component carrier with reliable electrical interconnections, in particular comprising a high aspect ratio, can be provided in an efficient manner, when through holes in a support layer structure are filled with a metal paste filling material, which material is then covered by a metal pad that comprises at least partially the same material as the metal paste filling material.

Conventionally, through-holes are filled using a plating process, requiring a seed layer at first, thereby making it eventually a challenge to form high aspect ratio vias.

It has been found by the inventors that the provision of a seed layer may be omitted, while still efficiently filling the through-hole, when a metal paste filling material is used. The metal paste may efficiently fill up the through-hole without the need for a seed layer and may be solidified later-on using a sintering process. The metal pad (e.g. for electrical contact) may be formed in the same process, comprising also metal paste filling material. In another embodiment, the metal pad may be additionally formed directly on the metal paste filling material, e.g. using a plating processes. Yet, the integrity and overall quality may be kept constant, since the metal paste filling material and the metal pad comprise at least partially of the same material, e.g. copper.

### Exemplary Embodiments

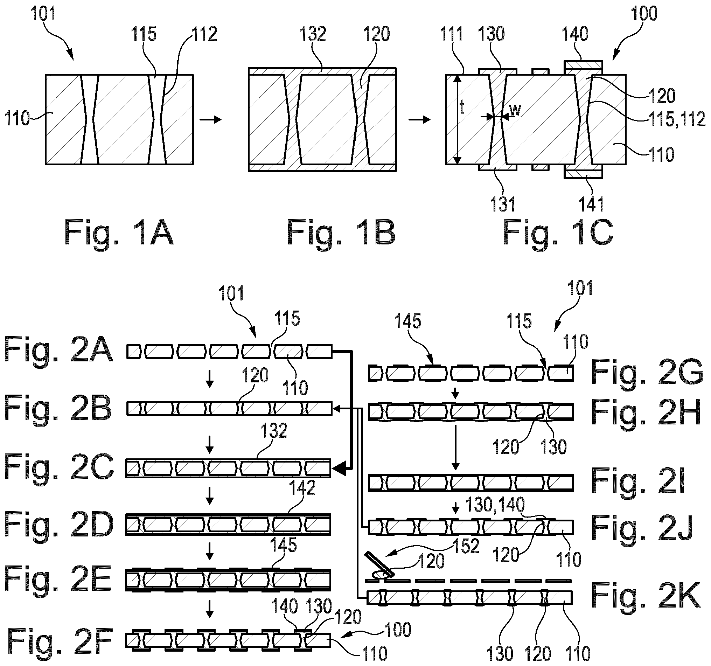

According to an embodiment, a ratio (thickness/width) between a thickness (along vertical direction Z) of the support layer structure and a minimum width (along X, Y) of the through-hole is at least 5, in particular at least 6, more in particular at least 7, more in particular at least 8, more in particular at least 9. In a further example, the ratio is in the range 5 to 10. In another example, the ratio is 10 or less. This may provide the advantage that an interconnection (in particular a via) through the support layer structure with a high aspect ratio, i.e. a long and thin shape, can be efficiently provided. In case of an interconnection (through-hole) with straight sidewalls, the width would be constant along the entire length (along Z). Yet, in case of slanted (tapering) sidewalls, the width of the interconnection may vary along the thickness direction. In the present case, the minimum width may be chosen for calculating the aspect ratio. For example, in case of an hourglass shape of the through-hole (see e.g. Figure 1), the minimum width of the hourglass (where a through hole portion from the top meets a through-hole portion from the bottom) may be seen as the minimum width of the through-hole.

According to a further embodiment, the support layer structure is configured as a support plate. This may provide the advantage of a certain robustness. For example, the support layer structure may serve as a core layer structure to stabilize a component carrier layer stack. In another example, the support layer structure may be used as a mounting plate for a (electronic) component to be mounted on and/or embedded in the component carrier layer stack.

According to a further embodiment, the support layer structure comprises or consists of one of the following: glass, ceramic, a semiconductor, silicon carbide, or carbon, i.e. graphene (in other words a non-resin material). By having a glass layer structure, it may be possible to implement an electrically insulating material layer having a good mechanical stability, with excellent electrically insulating and barrier properties in respect to, in particular chemical, species. A ceramic layer structure may be made subject of high processing temperatures, while a semiconductor may provide specific electric properties.

In the context of the present document, the term "glass layer structure" may in particular refer to a layer structure that comprises glass material. In this context, the term "glass" may in particular refer to a non-crystalline and amorphous solid. In an example, the glass comprises silicate (silicate glass), in particular silicon dioxide (SiO₂). In a further example, the glass comprises borosilicate (borosilicate glass) or aluminosilicate (aluminosilicate glass). In a further example, the glass comprises at least one silane and/or siloxane compound. In yet another example, the glass may comprise functional groups, e.g. hydrophilic and/or hydrophobic functional groups, in particular at the main surfaces. Since the glass layer is a (continuous or discontinuous) layer, it comprises two main surfaces opposite to each other.

According to a further embodiment, the thickness of the support layer structure is at least 500 µm, in particular in a range from 500 µm to 2000 µm. This may provide the advantage that a robust (due to a certain thickness) support structure is obtained that enables long (yet thin) interconnections. This may provide a solution for big form factor product and application for high density and high performance computing.

According to a further embodiment, the metal paste filling material is in direct physical contact with sidewalls of the support layer structure delimiting the through-hole, in particular without a further structure (in particular a seed layer and/or a plating layer) in between. Thereby, the provision of a seed layer (generally necessary in case of via plating) can be omitted and the manufacture process may be more efficient and flexible.

According to a further embodiment, the metal paste filling material does not (directly physically) contact with sidewalls of the support layer structure (through hole). There might be a metal layer (like electroless deposition layer or sputtering layer as seed layer) formed on the sidewall of the through hole (before that, it should have a treatment on the surface of glass to improve the adhesion), which might increase the electrical conductivity of through connection between the glass layer support structure and the other layers for the whole component carrier after filling the through hole with metal paste.

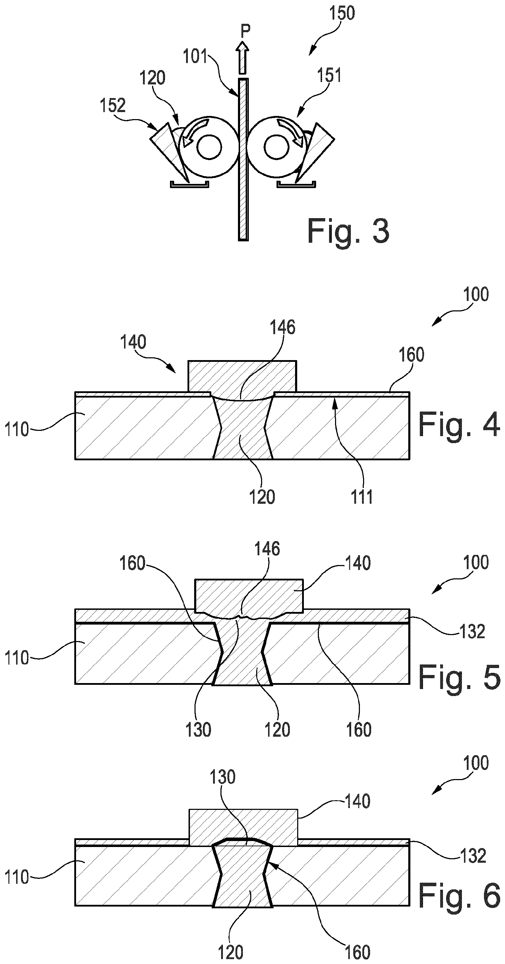

According to a further embodiment, a seed layer is arranged between at least part of the through-hole sidewall and the metal paste filling material (see Figures 5 and 6). The seed layer may hereby promote the adhesion between the (glass) support layer structure material and the metal paste filling material.

According to a further embodiment, the metal pad is a plating pad (provided by a plating process) or the component carrier further comprises a plating pad (provided by a plating process) on top of the metal pad. As described above, the metal pad can be in one example an additional structure, e.g. provided by plating (and comprising at least partially the same material as the metal paste filling material, e.g. copper). As further described above, the metal pad may be formed by the same material as the metal paste filling material, e.g. as a metal paste filling material pad. It can be preferable that the metal pad is formed by copper and the paste has an efficient electrical conductivity and there is a robust adhesion between the (glass) support layer and the metal layer.

According to a further embodiment, the through-hole has slanted sidewalls along its entire extension. This structural feature may reflect a manufacture process of laser drilling and/or etching.

According to a further embodiment, the through-hole has (essentially) straight sidewalls along its entire extension. This structural feature may reflect a manufacture process of mechanical drilling.

According to a further embodiment, the through-hole has an hourglass shape. This structural feature may reflect a manufacture process of forming a first through-hole portion from the top and a second through-hole portion from the bottom, which then meet within the support layer structure, in particular in the center/middle. The tapering of the through-hole portion may reflect a manufacture step of laser drilling (or etching).

According to a further embodiment, the through-hole has a continuously tapering shape or a continuously straight shape.

According to a further embodiment, the component carrier further comprising: a further metal pad on an opposing main surface of the support layer structure and on an opposing end of the metal paste filling material. This may provide the advantage that the interconnection serves as an efficient via through-connection that can be electrically contacted at the top and bottom. Further, a symmetric structure for the product can be provided, wherein the symmetric structure may suppress warpage.

According to a further embodiment, the further metal pad is a plating pad or a metal pad is formed by the metal paste or a metal pad is formed with the mixture of plating pad and metal paste. The component carrier can further comprise a further plating pad on top of the further metal pad (see above).

According to a further embodiment, the metal paste filling material comprises metal particles. Metal particles may be highly suitable since they offer an efficient electric conductivity and/or can be solidified and/or bonding together in a sintering process. The metal paste filling material may further comprise a bonding material to thereby form a paste/ink (a material with a certain viscosity) from the metal particles. The metal paste filling material may comprise e.g. copper nano/micro particles. In an example, the particles may comprise further materials, e.g. polymers, small ligands, a metal shell (e.g. Ag, Ni, Sn), an oxide (e.g. copper oxide) shell, a carbon shell, etc.

According to a further embodiment, the metal paste filling material comprises nano metal particles (NMP). This may provide the advantage that an established and well-suited material can be directly applied and the manufacturing could be less complex with higher efficiency and better compatibility for via with different sizes and eco-friendliness. Additionally, the handling of the (glass) support layer structure may be easier and less chance to be broken. In a further example, the metal particles comprise micro metal particles or a mixture of nano metal particles and micro metal particles.

The nano metal particle and micro metal particles can have sphere-like, crystal-like or other shapes could be also applicable. It may be important that the metal particles can have a contact area as large as possible and then it can have less resistance and efficient electrical conductivity after bonding with each other by sintering.

According to a further embodiment, at least some of the metal particles are bound to each other. Thereby, the stability may be increased. Some particles may bond together initially, or the bonding may be promoted by a bonding material. Further, a sintering process can cause the bonding of particles.

Generally, metal particle may be coated with some metal material such as Sn, Cu, Ag, Au. After treatment with high temperatures, the coating material will be melted together and then different particles bond together or move together, surrounded by the melted coating material.

According to a further embodiment, the metal paste filling material comprises or consists of sintered particles. This may provide the advantage that the paste can be hardened/solidified in an efficient and established manner and can contact/bond with each other very tightly to provide a good electrical conductivity for the connection of component carrier.

According to a further embodiment, at least some metal particles have a different material than the material of the metal pad. For example, the metal particles have a material that provides specific desired properties for the electrical conductivity and mechanical stability. Even in this case, both, the paste and the metal pad, can comprise similar material(s), e.g. copper.

According to a further embodiment, the metal paste filling material is a porous material. This structural feature may directly reflect a manufacture process using sintering (e.g. of nano metal particles).

According to a further embodiment, the at least on through-hole comprises a (total) volume, wherein at least 50%, in particular at least 60%, of the (total) volume is occupied by the at least some metal particles. This may bring the advantage of ensuring reliable electric conduction.

According to a further embodiment, the at least some metal particles are in direct contact with the support layer structure and the metal pad. This may bring the advantage of having a reliable integration of the metal paste filling material within the component carrier.

According to a further embodiment, the component carrier is configured as an inlay for a further component carrier layer stack. This may provide the advantage that the described component can be applied in a highly design-flexible manner. For example, the component carrier may be manufactured in a separate process (compared to the further component carrier) and then assembled to the further component carrier, e.g. mounted on and/or embedded in. According to a further embodiment, there is provided the further component carrier, comprising a layer stack and the component carrier inlay.

According to a further embodiment, a portion of the metal paste filling material extends into the metal pad (see Figure 6). This may provide the advantage that over-filling of the through-hole with metal paste filling material can be easily cured by letting the metal paste filling material extend into the metal pad. Since metal paste filling material and metal pad comprise at least partially the same material, the overall component carrier quality may not be affected and the adhesion between the metal layer and glass core may be guaranteed.

According to a further embodiment, a portion of the material of the metal pad extends into the metal paste filling material, in particular internally with respect to the exterior main surface of the support layer structure (see Figures 4 and 5). This may provide the advantage that under-filling of the through-hole with metal paste filling material can be easily cured by letting the metal pad material fill a void (dimple/recess) causes by the under-fill and the dimple or recess can be filled in by electrical plating, in particular when the metal paste filling material is filled in the through hole with less volume or there will be a grinding process provided on the surface of the (glass) support layer structure after the metal paste filling process. Since metal paste filling material and metal pad comprise at least partially the same material, the overall component carrier quality may not be affected and the electrical conductivity may be supported.

According to a further embodiment, the portion of the metal paste filling material extending into the metal pad or the portion of the metal pad extending into the metal paste filling material comprises a round shape along the stack thickness direction (z), in particular a dome-like shape (concave/convex) (see Figures 4 to 6). Such a shape may be a structural feature that reflects an under-fill or an overfill with metal paste filling material. Advantageously, such a structural feature may be compensated efficiently and reliably by providing the metal pad (at least partially comprising the same material).

According to a further embodiment, the portion of the metal paste filling material extending into the metal pad or the portion of the metal pad extending into the metal paste filling material at least partially fills a void (dimple, recess) caused by an external roughness of the corresponding metal pad or metal paste filling material. In this example, the defect may be caused by a treatment process (in particular grinding) of removing material from the support layer structure main surface, thereby eventually causing a roughening.

According to a further embodiment, the metal pad is made of (exactly) the same material as the metal paste filling material, in particular wherein the metal pad forms a metal paste filling material pad on top, in particular in direct contact, of the metal paste filling material (see the portion J of Figure 2). In this example, the metal paste filling material and the metal pad may be advantageously formed in one and the same manufacture process.

According to a further embodiment, the method further comprising: sintering the metal paste filling material after filling the metal paste filling in the through-hole. Accordingly, the metal paste filling material may be turned into a reliable via interconnection using established and straightforward technical means.

In the context of the present document, the term "sintering" may in particular refer to a process of compacting a material and forming a solid mass of said material by pressure and/or heat, in particular without melting the material to the point of liquefaction. For example, the sintering may cause metal particles to fuse together and thereby form a solidified metal piece. In one example, the sintering may cause small pores between the particles (e.g. using nano particles), while in another example, the sintering may cause only point contacts between the particles (e.g. using micro particles). A combination of nano particles and micro particles may cause a nano-welding between the micro particles (in particular essentially no pores). The sintering process may be realized using an oven (i.e. heating, e.g. 200°C or more). In another example, the sintering may be performed by laser sintering.

According to a further embodiment, the method further comprising: sintering or plating the metal pad, in particular after sintering the metal paste filling material. As described above, the metal pad may be provided by metal paste filling material (and in the same process) or may be provided in a further process, e.g. plating.

According to a further embodiment, the method further comprising: forming, in particular plating, a plating pad on top of the metal pad. In particular when the metal pad is formed of metal paste filling material, an additional pad may be formed by a plating process (see e.g. the portion F of Figure 2).

According to a further embodiment, filling the through-hole with the metal paste filling material is done by a roll coating machine. An example of such a machine is described with respect to Figure 3. For example, a roller may be used to distribute the metal paste filling material on the support layer structure and to squeeze it into the through-holes. Additionally or alternatively, a screen and stencil approach (see the portion K of Figure 2) may be applied for filling the through-holes. In summary, established technologies may be directly implemented in a straightforward manner to fill the through-holes in an efficient and reliable manner with the metal paste filling material.

In an embodiment, the component carrier is configured as one of the group consisting of a printed circuit board, a substrate (in particular an IC substrate), and an interposer.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

### Brief Description of the Drawings

The aspects defined above and further aspects of the invention are apparent from the examples of embodiment to be described hereinafter and are explained with reference to these examples of embodiment.
Portions A to C of Figure 1 show a method of manufacturing a component carrier according to an exemplary embodiment of the invention. The portion C of Figure 1 shows hereby the component carrier according to an exemplary embodiment of the invention.
Portions A to K of Figure 2 show a method of manufacturing a component carrier according to an exemplary embodiment of the invention in more detail.
Figure 3 shows a roll coating machine for performing a method of manufacturing a component carrier according to an exemplary embodiment of the invention.
Figures 4 to 6 respectively show a connection between metal paste filling material and metal pad according to exemplary embodiments of the invention.

### Detailed Description of the Drawings

**Portions A to C of** **Figure 1** show a method of manufacturing a component carrier 100 according to an exemplary embodiment of the invention.

The portion A of Figure 1: a support layer structure 110 (being here a component carrier preform 101) is provided that is configured as a glass core layer structure. Through holes 115 are formed through said support layer structure 110 along the vertical direction (Z), being perpendicular to the directions (X, Y) of main extension. In this example, the through holes 115 have slanted sidewalls 112 (e.g. from laser drilling) and have been formed in two steps respectively: a first hole portion is formed from top to bottom, while a second hole portion is formed from bottom to top, thereby connecting to the first hole portion. Since the sidewalls 112 are tapering towards the center of the support layer structure 110, an hour-glass-like structure is obtained. The through-holes 115 have slanted sidewalls 112 along its entire extension and are continuously tapering.

The portion B of Figure 1: a metal paste filling material 120 is provided in the through holes 115 by roller coating or electroless deposition combined with electroplating, thereby filling them up completely. Besides the through-holes 115, a layer 132 of the metal paste filling material 120 is deposited on the top main surface 111 and the bottom main surface of the support layer structure 110. The layer 132 could comprise a seed metal layer formed by electroless deposition or sputtering.

The portion C of Figure 1: the layer 132 of the metal paste filling material 120 is patterned, so that on top (and bottom) of each filled through-hole 115 a metal paste filling material pad 130 is arranged and in direct contact with the metal paste filling material 120 located in the through-hole 115. Further, on top of the metal paste filling material 120 (in particular the pad 130), a metal pad 140 is formed. Below the metal paste filling material 120 (in particular a further pad 131) at the bottom side, a further metal pad 141 is formed. The metal pad 140 and the metal paste filling material 120 comprise at least partially the same material, e.g. metal (copper) particles. In one example, the metal pad 140 is formed from a metal paste material, while in another example, the metal pad 140 is formed by plating. In another example, the extension of the metal pad 140 in main extension (X,Y) is the same as the extension of the further metal pad 141. Alternatively, the extension of the metal pad 140 in main extension (X,Y) is larger than the extension of the further metal pad 141 (not shown). The metal paste filling material 120 is sintered to form a stable interconnection through the support layer structure 110. The support layer structure 110 forms part of a layer stack (not shown) in the final component carrier product 100. The metal paste filling material 120 is in direct physical contact with sidewalls 112 of the support layer structure 110 delimiting the through-hole 115 without a plating structure (or a seed layer) in between.

In other words, the metal paste filling material is connecting with sidewalls 112 through another thin metal layer formed by electroless deposition or sputtering (the thin metal layer is directly connecting with the sidewall and the thin metal layer is directly connecting with the metal paste filling material). With such a method, the electrical conductivity of the component carrier or the support layer structure (it could be glass core) will be improved.

It can be seen that a ratio between a thickness t of the support layer structure 110 and a minimum width w of the through-hole 115 is at least 5, i.e. there is a high aspect ratio. In a specific example, the thickness t of the support layer structure 110 is at least 500 µm, in particular in a range from 500 µm to 2000 µm.

**The portions A to K of** **Figure 2** show a method of manufacturing a component carrier 100 according to an exemplary embodiment of the invention in more detail.

The portion A of Figure 2: there is provided a support layer structure 110 (being a glass substrate or glass core) as a component carrier preform 101. Through-holes 115 are formed as described above using a laser (e.g. CO₂, UV, excimer). An optional surface pre-treatment can be performed (e.g. SiN, coupling, plasma, roughening, etc.).

The portion B of Figure 2: the through-holes 115 are filled with metal paste filling material (so-called plugging) 120, comprising e.g. copper nano metal particles (NMP) and a bonding material, such as resin or other material to improve the adhesion among all the elements or compounds inside of the metal paste filing material and mechanical stability of the metal paste filing material. Additionally, the metal paste filling material can also comprise some solvent. Then, a (vacuum) sintering step is performed to sinter the metal paste filling material 120 in the through-holes 115. Thereby, the compounds of metal paste filing material will be bonded together and the material will realize the electrical conductivity as conductors.

The portion C of Figure 2: further metal paste filling material 120 is provided on the top and the bottom main surface of the support layer structure 110, thereby forming a layer 132 of metal paste filling material. The provision can be done for example by roll coating (see Figure 3).

The portion D of Figure 2: a further (vacuum) sintering step is performed to sinter also the layer 132 of metal paste filling material. Then, a metal layer (e.g. copper) 142 is formed on top of the layer 132 of metal paste filling material. The formation of the metal layer 142 can be done in an electro-less manner and/or by plating. Plating can also be done on an electro-less seed layer (not shown).

The portion E of Figure 2: in order to pattern the metal layer 142, a dielectric film 145 is provided by lamination as a protection at the locations, where the metal layer 142 should remain.

The portion F of Figure 2: at the location, where no dielectric film 145 is situated, the metal layer 142 and the layer 132 of metal paste filling material is removed, e.g. by etching. Then, the dielectric film 145 is stripped. The remaining component carrier 100 is comparable to the one shown in the portion C of Figure 1: on top (and bottom) of each through-hole 115 (being filled by sintered metal paste filling material 120), there is arranged a metal paste filling material pad 130 and a metal pad 140. In this embodiment, the metal pad 140 is a plating pad that originates from patterning the metal layer 142.

The portions G to J of Figure2 illustrate an alternative manufacture process.

The portion G of Figure 2: the two main surfaces of the support layer structure 110 are covered respectively with a dielectric image film 145 (e.g. thinner than 10 µm) at surface portion between the through-holes 115.

The portion H of Figure 2: the through-holes 115 are filled with the metal paste filling material 120 and metal paste filling material pads 130 are formed at the surface portions not covered by the dielectric image film 145. A sintering step (e.g. CO₂ laser sintering or oven cure) is performed to sinter the metal paste filling material 120 in the through-holes 115.

The portion I of Figure 2: the main surfaces of the support layer structure 110 are grinded to make the metal paste filling material pads 130 flush with the dielectric image film 145.

The portion J of Figure 2: the dielectric image film 145 is stripped, leaving behind the metal paste filling material pads 130. In this example, the metal paste filling material pads 130 can also be seen as metal pads 140. The obtained component carrier 100 is comparable with the one shown in the portion F of Figure 2 with the difference that the metal paste filling material pads 130 can be seen as the metal pads 140, while in the portion F of Figure 2, the metal pads 140 are separate structures formed on the metal paste filling material pads 130.

The portion K of Figure 2: this Figure illustrates a process step of filling the through-holes 115 with the metal paste filling material 120 using a stencil 152 and a screen.

**Figure 3** shows a roll coating machine 150 for performing a method of manufacturing a component carrier 100 according to an exemplary embodiment of the invention. A component carrier preform 101 (e.g. a panel comprising the support layer structure 110) is moved through the roll coating machine 150 in a process direction P, in this example in the vertical direction (from bottom to top). However, the process direction P (coating direction) can also be different, for example in the horizontal direction (perpendicular). By applying two direction coating together, the thickness of the coating layer could be more uniform.

The roll coating machine 150 comprises two rubber rollers 151 that rotate respectively and thereby transport the component carrier preform 101 in the process direction P. Squeegees 152 are used to provide metal paste filling material 120 to the rubber rollers 151, respectively, which transfer the metal paste filling material 120 to the component carrier preform 101 and press it into the through holes 115 thereof.

Figures 4 to 6 respectively show a connection between metal paste filling material 120 and metal pad 140 according to exemplary embodiments of the invention.

**Figure 4****:** this embodiment of the component carrier 100 shows the support layer structure 110 with a through-hole 115 filled with the metal paste filling material 120. On the upper main surface 111 of the support layer structure 110, a metal seed layer 160 has been deposited and on top of the metal paste filling material 120, a metal pad 140 (here a plated metal pad) is arranged. A portion 146 of the material of the metal pad 140 extends into the metal paste filling material 120 in a dome-like shape (convex) and internally with respect to the exterior main surface 111 of the support layer structure 110 (into the support layer structure 110). During the manufacturing, a metal paste filling material layer 132 (see e.g. the portion C of Figure 2) has been removed from the exterior main surface 111 by grinding, thereby roughening said exterior main surface 111. The metal seed layer 160 can thus adhere to the support layer structure 110 in a stable manner. Yet, there has been too less metal paste filling material 120 in the through-hole 115, resulting in a dimple/recess. The metal seed layer 160 follows the shape of the dimple, however, this defect is cured by the portion 146 of the material of the metal pad 140 that extends into the metal paste filling material 120. In other words, the portion 146 of the metal pad 140 extending into the metal paste filling material 120 at least partially fills a void caused by an external roughness of the corresponding metal paste filling material 120.

**Figure 5****:** this embodiment of the component carrier 100 shows the support layer structure 110 with a through-hole 115 filled with the metal paste filling material 120 and an exterior main surface 111 covered with a metal paste filling material layer 132 (compare the portion C of Figure 2). In this specific example, a seed layer 160 has been applied at the through-hole sidewalls and the exterior main surface 111. Said optional seed layer 160 can be provided e.g. by sputtering and can promote the adhesion between the support layer structure (glass) and the metal paste filling material 120. On top of the metal paste filling material 120, a metal pad 140 (here a plated metal pad) is arranged. Like in the example of Figure 4, an undesired dimple/recess has been formed between the metal paste filling material 120 and the metal pad 140. However, said defect is cured by the portion 146 of the material of the metal pad 140 that extends into the metal paste filling material 120.

**Figure 6****:** this embodiment of the component carrier 100 is very similar to the one described for Figure 5, yet with the difference being that not too less of the metal paste filling material 120 is present at the top of the through-hole 115, but too much. Accordingly, a concave dome-like shape (a round shape along the stack thickness direction z), of metal paste filling material 120 is formed and said portion 130 (can be seen as a metal paste filling material pad) of the metal paste filling material 120 extends into the metal pad 140.

### Reference signs

- 100: Component carrier
- 101: Component carrier preform, panel
- 111: Exterior main surface
- 115: Through hole
- 120: Metal paste filling material
- 130: Metal paste filling material pad
- 131: Further metal paste filling material pad
- 132: Metal paste filling material layer
- 140: Metal pad
- 141: Further metal pad
- 142: Metal/plating layer
- 145: Dielectric film
- 146: Extension of metal pad
- 150: Roll coating machine
- 151: Rubber roller
- 152: Squeegee
- 160: Seed layer

## Claims

1. A component carrier (100), comprising a stack having at least one electrically conductive layer structure and at least one electrically insulating layer structure, wherein the stack comprises:
a support layer structure (110) comprising at least one through-hole (115);
a metal paste filling material (120) in the through-hole (115); and
a metal pad (140) provided on and extending from an exterior main surface (111) of the support layer structure (110);
wherein the metal paste filing material (120) in the through hole (115) and the metal pad (140) comprise at least partially the same material.

2. The component carrier (100) according to claim 1, wherein at least one of the following features applies:
wherein a ratio between a thickness (t) of the support layer structure (110) and a minimum width (w) of the through-hole (115) is at least 5;
wherein the support layer structure (110) is configured as a support plate;
wherein the support layer structure (110) comprises or consists of one of the following: glass, ceramic, a semiconductor;
wherein the thickness (t) of the support layer structure (110) is at least 500 µm, in particular in a range from 500 µm to 2000 µm.

3. The component carrier (100) according to claim 1 or 2,
wherein the metal paste filling material (120) is in direct physical contact with sidewalls (112) of the support layer structure (110) delimiting the through-hole (115),
in particular without a further structure in between.

4. The component carrier (100) according to any one of the preceding claims,
wherein the metal pad (140) is a plating pad or
wherein the component carrier (100) further comprises a plating pad on top of the metal pad (140).

5. The component carrier (100) according to any one of the preceding claims, wherein at least one of the following features applies:
wherein the through-hole (115) has slanted sidewalls along its entire extension;
wherein the through-hole (115) has an hourglass shape;
wherein the through-hole (115) has a continuously tapering shape.

6. The component carrier (100) according to any one of the preceding claims, further comprising:
a further metal pad (141) on an opposing main surface of the support layer structure (110) and on an opposing end of the metal paste filling material (120),
in particular wherein the further metal pad (141) is a plating pad or wherein the component carrier (100) further comprises a further plating pad (141) on top of the further metal pad.

7. The component carrier (100) according to any one of the preceding claims, wherein the metal paste filling material (120) comprises metal particles and at least one of the following features:
the metal paste filling material (120) comprises nano metal particles;
at least some of the metal particles are bound to each other;
the metal paste filling material (120) comprises or consists of sintered particles;
at least some metal particles have a different material than the material of the metal pad (140);
the metal paste filling material (120) is a porous material.

8. The component carrier (100) according to any one of the preceding claims, configured as an inlay for a further component carrier layer stack.

9. The component carrier (100) according to any one of the preceding claims,
wherein a portion (130) of the metal paste filling material (120) extends into the metal pad (140); and/or
wherein a portion (146) of the material of the metal pad (140) extends into the metal paste filling material (120), in particular internally with respect to the exterior main surface (111) of the support layer structure (110).

10. The component carrier (100) according to claim 9,
wherein the portion (130) of the metal paste filling material (120) extending into the metal pad (140) or the portion (146) of the metal pad (140) extending into the metal paste filling material (120) comprises a round shape along the stack thickness direction (z), in particular a dome-like shape; and/or
wherein the portion (130) of the metal paste filling material (120) extending into the metal pad (140) or the portion (146) of the metal pad (140) extending into the metal paste filling material (120) at least partially fills a void caused by an external roughness of the corresponding metal pad (140) or metal paste filling material (120).

11. The component carrier (100) according to any one of the preceding claims, wherein the metal pad (140) is made of the same material as the metal paste filling material (120), in particular wherein the metal pad (140) forms a metal paste filling material pad (130) on top, in particular in direct contact, of the metal paste filling material (120).

12. A method of manufacturing a component carrier (100), wherein the method comprises:
providing a stack with at least one electrically conductive layer structure, at least one electrically insulating layer structure, and a support layer structure (110);
forming a through-hole (115) in the support layer structure (110);
filling the through-hole (115) with a metal paste filling material (120), comprising metal particles and a bonding material; and
forming a metal pad (140) on and extending from an exterior main surface (111) of the support layer structure (110);
wherein the metal paste filing material (120) in the through hole (115) and the metal pad (140) comprise at least partially the same material.

13. The method according to claim 12, further comprising:
sintering the metal paste filling material (120) after filling the metal paste filling material (120) in the through-hole (115),
in particular further comprising:
sintering or plating the metal pad (140), in particular after sintering the metal paste filling material (120).

14. The method according to claim 12 or 13, further comprising:
forming, in particular plating, a plating pad on top of the metal pad (140).

15. The method according to any one of claims 12 to 14,
wherein filling the through-hole (115) with the metal paste filling material (120) is done by a roll coating machine (150).
